# EUROPEAN PATENT SPECIFICATION

(11) **EP 3 523 827 B1**
(45) Date of publication and mention of the grant of the patent: **10.05.2023**
(21) Application number: 16894807.3
(22) Date of filing: 09.10.2016
(51) Int. Cl.: H01L 27/32, H01L 51/52

(54) **ORGANIC LIGHT EMITTING DIODE DISPLAY PANEL, DISPLAY APPARATUS HAVING THE SAME, AND FABRICATING METHOD THEREOF**
ANZEIGETAFEL MIT ORGANISCHER LEUCHTDIODE, ANZEIGEVORRICHTUNG DAMIT UND HERSTELLUNGSVERFAHREN DAFÜR
PANNEAU D'AFFICHAGE À DIODES ÉLECTROLUMINESCENTES ORGANIQUES, APPAREIL D'AFFICHAGE LE COMPRENANT, ET LEUR PROCÉDÉ DE FABRICATION

(43) Date of publication of application: 14.08.2019
(73) Proprietor: BOE Technology Group Co., Ltd., Beijing 100015 (CN)
(72) Inventor: ZHAO, Dejiang, Beijing 100176 (CN)
(74) Representative: Lavoix
(86) International application number: PCT/CN2016/101561
(87) International publication number: WO 2018/064830

(56) References cited:
- EP-A1- 3 026 725
- EP-A2- 2 738 830
- CN-A- 101 452 947
- CN-A- 101 840 998
- CN-A- 103 024 960
- CN-A- 105 261 632
- CN-A- 105 590 954
- CN-A- 105 810 711
- JP-A- 2014 093 288
- KR-A- 20160 017 339
- KR-A- 20160 062 661
- US-A1- 2005 236 629
- US-A1- 2012 217 516

## Description

### TECHNICAL FIELD

The present invention relates to an organic light emitting diode display panel, a display apparatus having the same, and a fabricating method thereof.

### BACKGROUND

Organic light emitting diode (OLED) display apparatuses are self-emissive devices, and do not require backlights. OLED display apparatuses also provide more vivid colors and a larger color gamut as compared to the conventional liquid crystal display (LCD) apparatuses. Further, OLED display apparatuses can be made more flexible, thinner, and lighter than a typical LCD.

An OLED display apparatus typically includes an anode, an organic layer including a light emitting layer, and a cathode. OLEDs can either be a bottom-emission type OLED or a top-emission type OLED. In bottom-emission type OLEDs, the light is extracted from an anode side. In bottom-emission type OLEDs, the anode is generally transparent, while a cathode is generally reflective. In a top-emission type OLED, light is extracted from a cathode side. The cathode is optically transparent, while the anode is reflective.

EP3026725A1 discloses a see-through organic light emitting display device in which an area of a see-through region is maximized by using a transparent auxiliary electrode and a method for manufacturing the same.

KR20160062661A discloses a transparent organic light emitting display device and a method of manufacturing the same.

EP2738830A2 discloses an organic light-emitting display device and a method of manufacturing the same.

CN105590954A discloses an OLED display panel and a method of fabricating the same.

US2012/217516A1 discloses a light-emitting device utilizing electroluminescence and an electronic device using the light-emitting device.

KR20160017339A discloses an organic light emitting display device and a method for manufacturing the organic light emitting display device.

### SUMMARY

In one aspect, the present invention provides an organic light emitting diode display panel according to claim 1.

In another aspect, the present invention provides a display apparatus according to claim 6. In another aspect, the present invention provides a method of fabricating an organic light emitting diode display panel according to claim 7.

Preferred embodiments of the invention are the subject matter of the dependent claims, whose content is to be understood as forming an integral part of the present description.

### BRIEF DESCRIPTION OF THE FIGURES

The following drawings are merely examples for illustrative purposes according to various disclosed embodiments and are not intended to limit the scope of the present invention.
FIG. 1 is a diagram illustrating the structure of an organic light emitting diode display panel according to the claimed invention.
FIG. 2 is a diagram illustrating the structure of an organic light emitting diode display panel not forming part of the claimed invention.
FIG. 3 is a diagram illustrating the structure of an organic light emitting diode display panel not forming part of the claimed invention.
FIG. 4 is a diagram illustrating a process of fabricating an auxiliary electrode layer in some embodiments.
FIGs. 5A-5D illustrate a process of fabricating an organic light emitting diode display panel in some embodiments.

### DETAILED DESCRIPTION

The disclosure will now describe more specifically with reference to the following embodiments. It is to be noted that the following descriptions of some embodiments are presented herein for purpose of illustration and description only. It is not intended to be exhaustive or to be limited to the precise form disclosed. Apparently, scope of the invention is defined by the scope of the appended claims.

In a top-emission type OLED, the cathode may be formed from a transparent conductive material such as indium tin oxide and/or thin transparent metals such as magnesium and silver. A metal cathode may have better electrical conductivity than a cathode formed from indium tin oxide. However, a metal cathode must be made very thin in order to be optically transparent. In a thin metal layer, the sheet resistance is relatively large, as compared to one having a larger thickness (e.g., the anode). Due to the large sheet resistance, greater power may be required to operate the top-emission type OLED. This issue becomes particularly challenging in large-size display panels.

In some embodiments, the cathode may be made of a transparent indium tin oxide material. Because indium tin oxide is a transparent material, the cathode made of indium tin oxide may have a relatively larger thickness. However, typically indium tin oxide can only be effectively deposited on a substrate by sputtering. It was discovered in the present disclosure that the sputtering process of indium tin oxide damages the organic layer, resulting in a reduced life time and inferior properties.

In some embodiments, an auxiliary electrode may be added in a layer on top of the cathode layer, electrically connected to cathode through a via. However, it was discovered in the present disclosure that sometimes at least some of the vias may be covered or clogged during the process of forming the auxiliary electrode using a mask plate. As a result, the auxiliary electrode is not electrically connected to the cathode, leading to defects in image display, e.g., mura defects.

Accordingly, the present invention provides, *inter alia,* an organic light emitting diode display panel having a novel structure, a display apparatus having the same, and a fabricating method thereof that substantially obviate one or more of the problems due to limitations and disadvantages of the related art. In one aspect, the present invention provides an organic light emitting diode display panel having a plurality of pixels, each of which includes a subpixel region and an inter-subpixel region. The organic light emitting diode display panel includes a base substrate; a first electrode layer on the base substrate; a light emitting layer in the subpixel region on a side of the first electrode layer distal to the base substrate; a second electrode layer on a side of the light emitting layer distal to the first electrode layer; and an auxiliary electrode layer in the inter-subpixel region in a same layer as the second electrode layer. The auxiliary electrode layer and the second electrode layer are in contact with each other; and the auxiliary electrode layer has a thickness larger than that of the first portion of the second electrode layer.

In the claimed invention, a cross-section of the auxiliary electrode layer has an inverted trapezoidal shape. A short base of the inverted trapezoidal shape is on a side of the auxiliary electrode layer proximal to the first electrode layer, i.e., a long base of the inverted trapezoidal shape is on a side of the auxiliary electrode layer distal to the first electrode layer.

As used herein, a subpixel region refers to a light emission region of a subpixel, such as a region corresponding to a light emissive layer in an organic light emitting diode display. Optionally, a pixel may include a number of separate light emission regions corresponding to a number of subpixels in the pixel. Optionally, the subpixel region is a light emission region of a red color subpixel. Optionally, the subpixel region is a light emission region of a green color subpixel. Optionally, the subpixel region is a light emission region of a blue color subpixel. Optionally, the subpixel region is a light emission region of a white color subpixel.

As used herein, an inter-subpixel region refers to a region between adjacent subpixel regions, such as a region corresponding a pixel definition layer in an organic light emitting diode display. Optionally, the inter-subpixel region is a region between adjacent subpixel regions in a same pixel. Optionally, the inter-subpixel region is a region between two adjacent subpixel regions from two adjacent pixels. Optionally, the inter-subpixel region is a region between a subpixel region of a red color subpixel and a subpixel region of an adjacent green color subpixel. Optionally, the inter-subpixel region is a region between a subpixel region of a red color subpixel and a subpixel region of an adjacent blue color subpixel. Optionally, the inter-subpixel region is a region between a subpixel region of a green color subpixel and a subpixel region of an adjacent blue color subpixel.

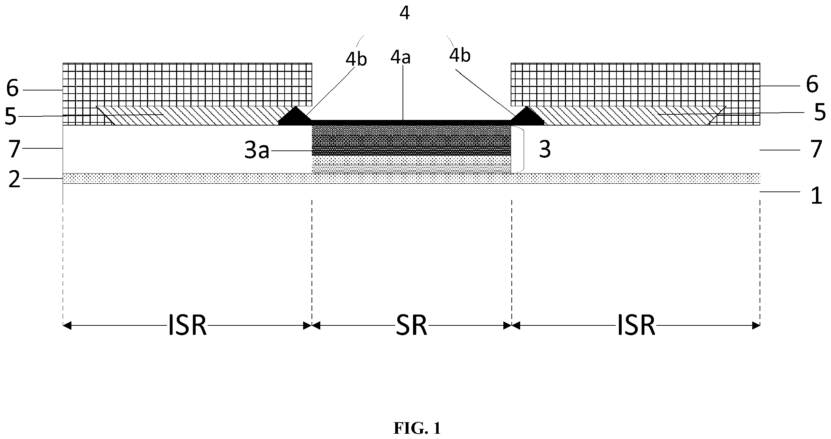

FIG. 1 is a diagram illustrating the structure of an organic light emitting diode display panel according to the claimed invention. Referring to FIG. 1, the organic light emitting diode display panel includes a plurality of pixels, each of which includes a subpixel region SR and an inter-subpixel region ISR. The organic light emitting diode display panel includes a base substrate 1; a first electrode layer 2 on the base substrate 1; a light emitting layer 3a in the subpixel region SR on a side of the first electrode layer 2 distal to the base substrate 1; a second electrode layer 4 on a side of the light emitting layer 3a distal to the first electrode layer 2; and an auxiliary electrode layer 5 in the inter-subpixel region ISR in a same layer as the second electrode layer 4. As shown in FIG. 1, the auxiliary electrode layer 5 and the second electrode layer 4 are electrically connected and in contact with each other. The auxiliary electrode layer 5 has a thickness larger than that of a first portion 4a of the second electrode layer 4, said first portion 4a being the portion of the second electrode in the subpixel region. Optionally, the light emitting layer 3a is a sub-layer of an organic layer 3 in the organic light emitting diode display panel. Optionally, the organic layer 3 further includes one or more additional organic functional layer.

Optionally, the first electrode layer 2 is an anode, and the second electrode layer 4 is a cathode.

Any appropriate electrode materials and any appropriate fabricating methods may be used to make the first electrode layer, the second electrode layer, and the auxiliary electrode layer. For example, an electrode material may be deposited on the base substrate (e.g., by sputtering or vapor deposition); and patterned (e.g., by lithography such as a wet etching process) to form these electrode layers. Examples of appropriate electrode materials include, but are not limited to, non-transparent metal materials such as silver, magnesium, aluminum, platinum, gold, copper, neodymium, lithium, and nickel; transparent electrode materials such as indium tin oxide, indium zinc oxide; transparent metals(e.g., nano-silver), and a combination (e.g., alloys or laminates) thereof.

In the claimed invention, the organic light emitting diode display panel is a top-emission type display panel. In some embodiments, the first electrode layer is an anode layer, the second electrode layer is a cathode layer, and the auxiliary electrode layer is an auxiliary cathode layer. In a top-emission type display panel, the second electrode layer is a transparent electrode layer, and the first electrode layer is optionally a non-transparent electrode layer. Because the auxiliary electrode layer is disposed in the inter-subpixel region, it is a non-transparent electrode layer. The second electrode layer is a transparent electrode layer made of a transparent metal material, e.g., a transparent silver material, and the auxiliary electrode layer is a non-transparent metal electrode layer, and in some embodiments the second electrode layer and the auxiliary electrode layer may be made of a same metal material.

In a top-emission type display panel, the cathode made of a metal material is typically made be very thin in order to be optically transparent. By having an auxiliary cathode layer electrically connected to the cathode, the resistance of the cathode layer may be significantly reduced. The auxiliary cathode is disposed in the inter-subpixel region, thus it can be made thicker than the cathode layer. The cathode layer and the auxiliary cathode layer are in a same layer and in contact with each other, and a portion of the cathode layer in the subpixel region has a thickness much smaller than that of the auxiliary cathode layer.

In the claimed invention, a ratio between the thickness of the auxiliary cathode layer to the thickness of the first portion of the cathode layer is in a range of approximately 10 to approximately 100. A portion of the cathode layer in the subpixel region has a thickness in a range of approximately 5 nm to approximately 20 nm, e.g., approximately 5 nm to approximately 10 nm, approximately 10 nm to approximately 15 nm, and approximately 15 nm to approximately 20 nm. Optionally, the portion of the cathode layer in the subpixel region has a thickness of approximately 10 nm. The auxiliary electrode layer has a thickness in a range of approximately 50 nm to approximately 500 nm, e.g., approximately 50 nm to approximately 100 nm, approximately 100 nm to approximately 200 nm, approximately 200 nm to approximately 300 nm, approximately 300 nm to approximately 400 nm, and approximately 400 nm to approximately 500 nm. Optionally, the auxiliary electrode layer has a thickness of approximately 300 nm.

Referring to FIG. 1, the organic light emitting diode display panel in an embodiment further includes a pixel definition layer 6 in the inter-subpixel region ISR on a side of the auxiliary electrode layer 5 distal to the base substrate 1.

Any appropriate pixel definition materials and any appropriate fabricating methods may be used to make the pixel definition layer. For example, a pixel definition material may be deposited on the base substrate by a plasma-enhanced chemical vapor deposition (PECVD) process or a spin coating process. Examples of appropriate pixel definition materials include, but are not limited to, silicon oxide (SiO_{y}), silicon nitride (SiN_{y}, e.g., Si₃N₄), silicon oxynitride (SiOₓN_{y}), polyimide, polyamide, acryl resin, benzocyclobutene, and phenol resin. Optionally, the pixel definition layer may have a single-layer structure or a stacked-layer structure including two or more sub-layers (e.g., a stacked-layer structure including a silicon oxide sublayer and a silicon nitride sublayer). Optionally, the pixel definition layer divides each of the plurality of pixels into the subpixel region and the inter-subpixel region.

Referring to FIG. 1, in some embodiments, the organic light emitting diode display panel includes an organic layer 3 in the subpixel region SR on a side of the first electrode layer 2 distal to the base substrate 1, and the light emitting layer 3a is a sub-layer of the organic layer 3. Optionally, the organic layer 3 further includes one or more organic functional layer.

In some embodiments, the organic layer includes one or more organic functional layer between the light emitting layer and the first electrode layer in the subpixel region. Optionally, the one or more organic functional layer includes a carrier transport layer such as a hole transport layer. Optionally, the one or more organic functional layer includes a carrier injection layer such as a hole injection layer. Optionally, the organic layer includes a hole injection layer on a side of the first electrode layer distal to the base substrate, a hole transport layer on a side of the hole injection layer distal to the first electrode layer, and a light emitting layer on a side of the hole transport layer distal to the hole injection layer.

In some embodiments, the organic layer includes one or more organic functional layer between the light emitting layer and the second electrode layer in the subpixel region. Optionally, the one or more organic functional layer includes a carrier transport layer such as an electron transport layer. Optionally, the one or more organic functional layer includes a carrier injection layer such as an electron injection layer. Optionally, the organic layer includes an electron transport layer on a side of the light emitting layer distal to the first electrode layer, and an electron injection layer on a side of the electron transport layer distal to the light emitting layer.

Optionally, the organic layer includes a hole injection layer on a side of the first electrode layer distal to the base substrate, a hole transport layer on a side of the hole injection layer distal to the first electrode layer, a light emitting layer on a side of the hole transport layer distal to the hole injection layer, an electron transport layer on a side of the light emitting layer distal to the hole transport layer, and an electron injection layer on a side of the electron transport layer distal to the light emitting layer.

Referring to FIG. 1, in some embodiments, the organic light emitting diode display panel further includes an insulating layer 7 in the inter-subpixel region ISR on a side of the auxiliary electrode layer 5 proximal to the base substrate 1 (i.e., on a side of the first electrode layer 2 distal to the base substrate 1).

Any appropriate insulating materials and any appropriate fabricating methods may be used to make the insulating layer. For example, an insulating material may be deposited on the base substrate by a plasma-enhanced chemical vapor deposition (PECVD) process or a spin coating process. Examples of appropriate insulating materials include, but are not limited to, silicon oxide (SiO_{y}), silicon nitride (SiN_{y}, e.g., Si₃N₄), silicon oxynitride (SiOₓN_{y}), polyimide resin and polyester resin. Optionally, the insulating layer may have a single-layer structure or a stacked-layer structure including two or more sub-layers (e.g., a stacked-layer structure including a silicon oxide sublayer and a silicon nitride sublayer).

Optionally, the organic layer and the insulating layer are in a same layer. For example, the organic layer is in the subpixel region on a side of the first electrode layer distal to the base substrate, and the insulating layer is in the inter-subpixel region on a side of the first electrode layer distal to the base substrate. Optionally, the thickness of the organic layer is no greater than a thickness of the insulating layer so that the organic layer is not electrically connected to the auxiliary electrode layer on the insulating layer. Optionally, the organic layer and the insulating layer have a substantially the same thickness. Optionally, a surface of the organic layer on a side distal to the first electrode layer is substantially on a same level as a surface of the insulating layer distal to the base substrate. Optionally, a surface of the organic layer on a side distal to the first electrode layer is on a level lower than a surface of the insulating layer distal to the base substrate.

Referring to FIG. 1, the second electrode layer 4 in the claimed invention includes a first portion 4a in the subpixel region SR and a second portion 4b in the inter-subpixel region ISR. The first portion 4a is electrically connected to the auxiliary electrode layer 5 through the second portion 4b. In some cases, the second portion 4b may be considered as a connecting structure for electrically connecting the first portion 4a and the auxiliary electrode layer 5. Optionally, the first portion 4a and the second portion 4b are made of a same material (and in a same process). Optionally, the first portion 4a, the second portion 4b, and the auxiliary electrode layer 5 are made of a same material, however, the auxiliary electrode layer 5 is made in a process separate from that for the first portion 4a and the second portion 4b. Optionally, the first portion 4a and the second portion 4b are made of a material different from that of the auxiliary electrode layer 5, and are made in a process separate from that for the auxiliary electrode layer 5.

Referring to FIG. 1, the auxiliary electrode layer 5 has a cross-section having an inverted trapezoidal shape. In FIG. 1, the second portion 4b of the second electrode layer 4 has a cross-section having a triangular shape. Putting two together, the cross-sections of the auxiliary electrode layer 5 and the second portion 4b in the inter-subpixel region ISR have a parallelogram shape.

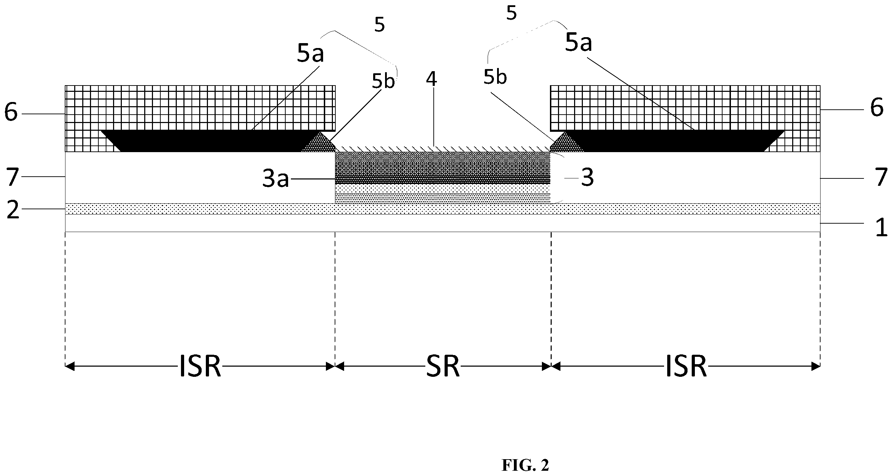

FIG. 2 is a diagram illustrating the structure of an organic light emitting diode display panel not forming part of the claimed invention. Referring to FIG. 2, the second electrode layer 4 is substantially limited in the subpixel region SR, and the auxiliary electrode layer 5 is substantially limited in the inter-subpixel region ISR. The auxiliary electrode layer 5 includes a first portion 5a and a second portion 5b. The second electrode layer 4 is electrically connected to the first portion 5a of the auxiliary electrode layer 5 through the second portion 5b. The second portion 5b may be considered as a connecting structure for electrically connecting the first portion 5a and the second electrode layer 4. Optionally, the second portion 5b and the second electrode layer 4 are made of a same material (and in a same process). Optionally, the first portion 5a, the second portion 5b, and the second electrode layer 4 are made of a same material, however, the first portion 5a is made in a process separate from that for the second portion 5b and the second electrode layer 4. Optionally, the second portion 5b and the second electrode layer 4 are made of a material different from that of the first portion 5a, and are made in a process separate from that for the first portion 5a.

The auxiliary electrode layer 5 in FIG. 2 has a cross-section having a substantially parallelogram shape. The first portion 5a has a cross-section having a substantially inverted trapezoidal shape. In FIG. 2, the second portion 5b has a cross-section having a substantially triangular shape. Putting two together, the cross-sections of the first portion 5a and the second portion 5b in the inter-subpixel region ISR have a substantially parallelogram shape. Optionally, the cross-section of the auxiliary electrode layer 5 has a substantially rectangular shape.

Optionally, the second portion 5b of the auxiliary electrode layer 5 has a cross-section having an irregular shape.

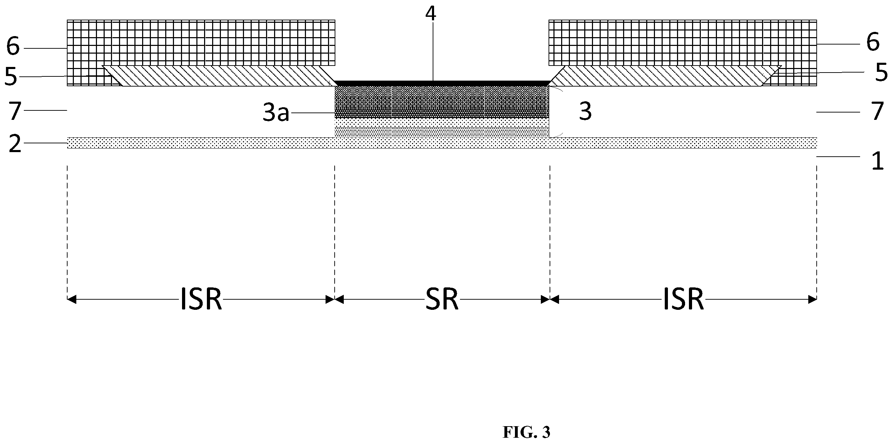

Numerous alternative embodiments may be practiced to make the second electrode layer and the auxiliary electrode layer. For example, in some embodiments, the auxiliary electrode layer is an integral electrode layer in the inter-subpixel region, and the second electrode layer is an integral electrode layer in the subpixel region. FIG. 3 is a diagram illustrating the structure of an organic light emitting diode display not forming part of the claimed invention. Referring to FIG. 3, the auxiliary electrode layer 5 has a cross-section having a substantially parallelogram shape. Optionally, the cross-section of the auxiliary electrode layer 5 has a substantially rectangular shape. Optionally, the auxiliary electrode layer 5 and the second electrode layer 4 are made of different materials and in separate processes. Optionally, the auxiliary electrode layer 5 and the second electrode layer 4 are made of a same material but in separate processes.

In another aspect, the claimed invention provides a method of fabricating an organic light emitting diode display panel having a plurality of pixels, each of which includes a subpixel region and an inter-subpixel region. In some embodiments, the method includes forming a first electrode layer on the base substrate; forming an auxiliary electrode layer in the inter-subpixel region in a same layer as the second electrode layer; forming a light emitting layer in the subpixel region on a side of the first electrode layer distal to the base substrate; and forming a second electrode layer on a side of the light emitting layer distal to the first electrode layer. The auxiliary electrode layer and the second electrode layer are formed to be in contact with each other; and the auxiliary electrode layer is formed to have a thickness larger than that of the first portion of the second electrode layer. the second electrode layer is formed to have a first portion in the subpixel region and a second portion in the inter-subpixel region; the first portion electrically connected to the auxiliary electrode layer through the second portion.

Any appropriate fabricating methods may be used to make the first electrode layer and the auxiliary electrode layer. For example, an electrode material may be deposited on the base substrate and patterned (e.g., by lithography such as a wet etching process) to form these electrode layers. Examples of deposition methods include, but are not limited to, sputtering (e.g., magnetron sputtering) and evaporation coating (e.g., a Chemical Vapor Deposition method, a Plasma-Enhanced Chemical Vapor Deposition (PECVD) method, a thermal vapor deposition method). In a magnetron sputtering process, magnetron sputtering apparatus induces plasma ions of a gas to bombard a target, causing surface atoms of the target material to be ejected and deposited as a film or layer on the surface of a substrate. For example, a metal electrode material or indium tin oxide may be used as the sputtering target, and a plasma including argon is used to bombard the sputtering target. The second electrode layer is formed according to claim 7.

Any appropriate electrode materials may be used to make the first electrode layer, as long as the second electrode layer is a transparent electrode layer made of a transparent metal material and the auxiliary electrode layer is a non-transparent electrode layer made of a non-transparent metal material. Examples of non-transparent metal materials are silver, magnesium, aluminum, platinum, gold, copper, neodymium, lithium, and nickel; an example of transparent metals is nano-silver.

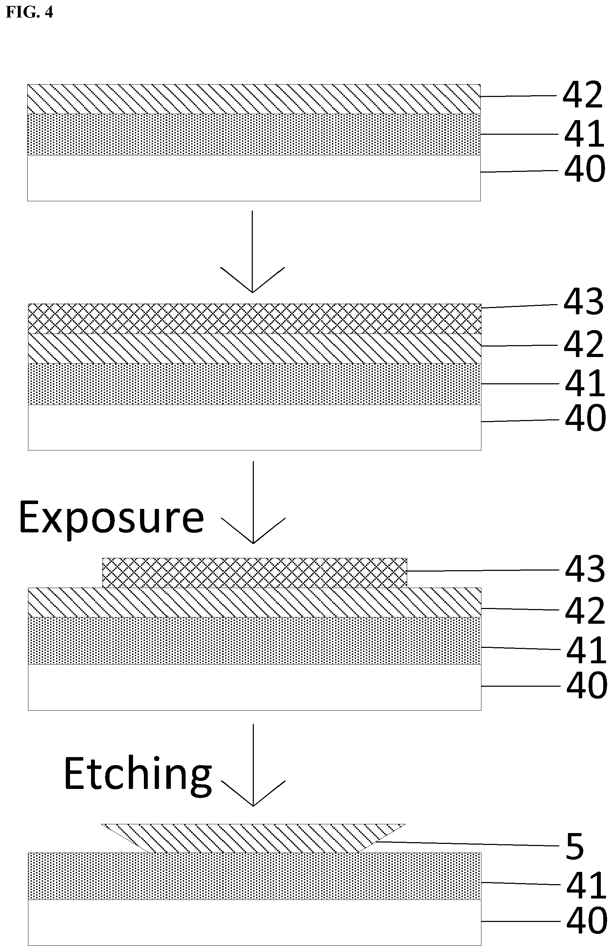

In some embodiments, the auxiliary electrode layer is fabricated by a lithography process. FIG. 4 is a diagram illustrating a process of fabricating an auxiliary electrode layer in some embodiments. Referring to FIG. 4, the lithography process in the embodiment includes depositing an auxiliary electrode material on a side of an insulating layer 41 distal to the base substrate 40, thereby forming an auxiliary electrode material layer 42. The process further includes depositing a photoresist layer 43 on a side of the auxiliary electrode material layer 42 distal to the insulating layer 41; exposing the photoresist layer 43 to UV light using a mask plate having a pattern corresponding to that of the auxiliary electrode layer; and removing the photoresist layer 43 in exposed regions. The photoresist layer 43 in a region corresponding to the auxiliary electrode layer remains. The auxiliary electrode material in the exposed region is then removed by etching, e.g., by wet etching, thereby forming an auxiliary electrode layer 5.

As shown in FIG. 4, the auxiliary electrode layer 5 has a cross-section having an inverted trapezoidal shape. A short base of the inverted trapezoidal shape is on a side of the auxiliary electrode layer 5 proximal to the insulating layer 41, i.e., a long base of the inverted trapezoidal shape is on a side of the auxiliary electrode layer 5 distal to the insulating layer 41. In embodiments not forming part of the claimed invention, the auxiliary electrode layer 5 has a cross-section having a substantially rectangular shape. In embodiments not forming part of the claimed invention, the auxiliary electrode layer 5 has a cross-section having a substantially parallelogram shape.

Optionally, the lithography process further includes baking the photoresist layer subsequent to removal of photoresist material in exposed regions and prior to etching of the auxiliary electrode material in the exposed region. Optionally, the baking parameters may be controlled to achieve a degree of hardness in the remaining photoresist layer 43. For example, the hardness of the remaining photoresist layer 43 may be adjusted by controlling the baking temperature, the baking duration, or a combination thereof. A relatively harder photoresist layer facilitates the formation of an auxiliary electrode layer 5 that has a cross-section having an inverted trapezoidal shape.

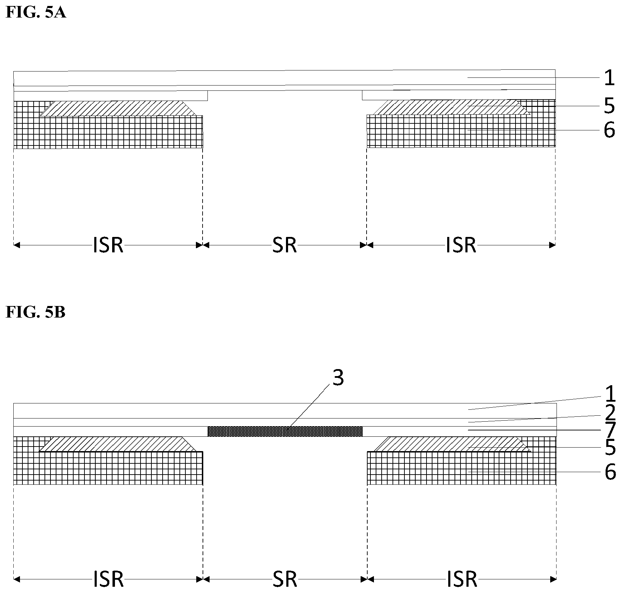

In some embodiments, subsequent to forming the second electrode layer, the method further includes forming a pixel definition layer in the inter-subpixel region on a side of the auxiliary electrode layer distal to the base substrate. FIGs. 5A-5D illustrate a process of fabricating an organic light emitting diode display panel in some embodiments. Referring to FIG. 5A, a pixel definition layer 6 is formed on a side of the auxiliary electrode layer 5 distal to the base substrate 1. The pixel definition layer 6 defines a subpixel region SR and an inter-subpixel region ISR in the display panel.

Referring to FIG. 5B, the method further includes forming an organic layer 3 (which includes a light emitting layer) in the subpixel region SR on a side of the first electrode layer 2 distal to the base substrate 1. Optionally, the thickness of the organic layer 3 is no greater than the thickness of the insulating layer 7. In FIG. 5B, the thickness of the organic layer 3 is substantially the same as the thickness of the insulating layer 7. Optionally, a surface of the organic layer 3 on a side distal to the first electrode layer 2 is substantially on a same level as a surface of the insulating layer 7 distal to the base substrate 1. Optionally, a surface of the organic layer 3 on a side distal to the first electrode layer 2 is on a level lower than a surface of the insulating layer 7 distal to the base substrate 1.

Various appropriate methods may be used to make the organic layer. For example, the light emitting layer and/or other organic functional layer of the organic layer may be formed by deposition methods or ink-jet printing methods. Examples of deposition methods include, but are not limited to, evaporation coating (e.g., a Chemical Vapor Deposition method, a Plasma-Enhanced Chemical Vapor Deposition (PECVD) method, a thermal vapor deposition method). Optionally, the organic layer is formed by ink-jet printing.

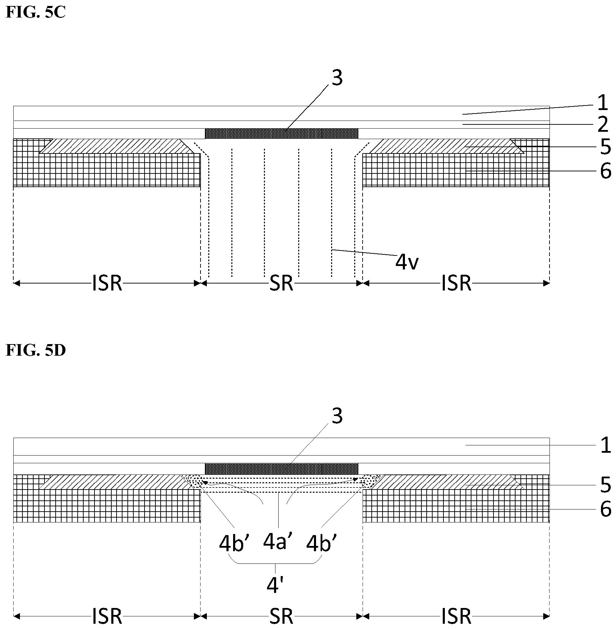

Referring to FIG. 5C, the method further includes forming a second electrode layer on a side of the organic layer 3 distal to the first electrode layer 2 by vapor depositing an electrode material 4v. The electrode material 4v is a metal material. In some examples, the electrode material is disposed in a vessel, and heated to cause the electrode material to evaporate (e.g., sublime). The vapor deposition rate may be controlled by the amount of heat applied to the electrode material. The thickness of the second electrode layer may be controlled by the vapor deposition rate and vapor deposition duration. As shown in FIG. 5C, the electrode material 4v evaporates and disperses from the vessel to the substrate having the organic layer 3 in the subpixel region SR.

Referring to FIG. 5D, when the vapor reaches the surface of the subpixel region SR, the vapor will disperse along the surface to two sides of the surface. Due to the shape of the auxiliary electrode layer 5, the vapor is prone to condense to a greater degree in regions at the interface between the subpixel region SR and the inter-subpixel region ISR. The cross-section of the auxiliary electrode layer 5 has an inverted trapezoidal shape, resulting in a groove region at the interface (corresponding to 4b' in FIG. 5D) having a triangular shaped cross-section. Due to constraint of the groove structure, the vapor more easily deposits inside the groove, forming electrode material deposition 4b' in the inter-subpixel region ISR. The vapor also deposits on the surface of the organic layer 3, forming electrode material deposition 4a' in the subpixel region SR. When the vapor deposition process is complete, the second electrode layer is formed on a side of the organic layer 3 distal to the first electrode layer 2. The second electrode layer so formed includes a first portion substantially in the subpixel region SR, and a second portion substantially in the inter-subpixel region ISR, the first portion electrically connected to the auxiliary electrode layer 5 through the second portion. The electrode material being a metal material, the second electrode layer is a thin film. The first portion of the second electrode layer is formed to have a thickness in a range of approximately 5 nm to approximately 20 nm; and the auxiliary electrode layer is formed to have a thickness in a range of approximately 50 nm to approximately 500 nm.

The auxiliary electrode layer has a cross-section having an inverted trapezoidal shape forming a structure (e.g., a groove structure) at the interface between the subpixel region and the inter-subpixel region to induce deposition of the electrode material vapor at the interface.

By having an auxiliary electrode layer, the resistance of the second electrode layer (e.g., a cathode) may be significantly reduced. By vapor depositing an electrode material to form the second electrode layer, damage to the organic layer during the electrode material deposition process (e.g., by sputtering) may be obviated. The present method provides an organic light emitting diode display panel have superior display qualities and an extended life time.

In another aspect, the present disclosure provides a display apparatus having an organic light emitting diode display panel described herein or fabricated by a method described herein. Examples of appropriate display apparatuses include, but are not limited to, an electronic paper, a mobile phone, a tablet computer, a television, a monitor, a notebook computer, a digital album, a GPS, etc.

The foregoing description of the embodiments of the invention has been presented for purposes of illustration and description. It is not intended to be exhaustive or to limit the invention to the precise form or to exemplary embodiments disclosed. Accordingly, the foregoing description should be regarded as illustrative rather than restrictive. Obviously, many modifications and variations will be apparent to practitioners skilled in this art. The embodiments are chosen and described in order to explain the principles of the invention and its best mode practical application, thereby to enable persons skilled in the art to understand the invention for various embodiments and with various modifications as are suited to the particular use or implementation contemplated. It is intended that the scope of the invention be defined by the claims appended hereto in which all terms are meant in their broadest reasonable sense unless otherwise indicated. Therefore, the term "the invention", "the present invention" or "the claimed invention" does not necessarily limit the claim scope to a specific embodiment, and the reference to exemplary embodiments of the invention does not imply a limitation on the invention, and no such limitation is to be inferred. The invention is limited only by the scope of the appended claims. Moreover, these claims may refer to use "first", "second", etc. following with noun or element. Such terms should be understood as a nomenclature and should not be construed as giving the limitation on the number of the elements modified by such nomenclature unless specific number has been given. Any advantages and benefits described may not apply to all embodiments of the invention. It should be appreciated that variations may be made in the embodiments described by persons skilled in the art without departing from the scope of the present invention as defined by the following claims.

## Claims

1. An organic light emitting diode display panel having a plurality of pixels, each of which includes a subpixel region and an inter-subpixel region, the organic light emitting diode display panel comprising:
a base substrate (1);
a first electrode layer (2) on the base substrate (1);
a light emitting layer (3a) in the subpixel region on a side of the first electrode layer (2) distal to the base substrate (1);
a second electrode layer (4) on a side of the light emitting layer (3a) distal to the first electrode layer (2); and
an auxiliary electrode layer (5) in the inter-subpixel region in a same layer as the second electrode layer (4), wherein the auxiliary electrode layer (5) and the second electrode layer (4) are in contact with each other;
wherein the second electrode layer (4) comprises a first portion (4a) in the subpixel region and a second portion (4b) in the inter-subpixel region, the first portion (4a) is electrically connected to the auxiliary electrode layer (5) through the second portion (4b), and the auxiliary electrode layer (5) has a thickness larger than that of the first portion (4a) of the second electrode layer (4);
the first portion (4a) of the second electrode layer (4) has a thickness in a range of 5 nm to 20 nm; the auxiliary electrode layer (5) has a thickness in a range of 50 nm to 500 nm;
the second electrode layer (4) is a transparent electrode layer made of a transparent metal material;
**characterized in that**
the auxiliary electrode layer (5) is a non-transparent electrode layer made of a non-transparent metal material;
a ratio between the thickness of the auxiliary electrode layer (5) to the thickness of the first portion (4a) of the second electrode layer (4) is in a range of 10 to 100; and
the auxiliary electrode layer (5) has a cross-section having an inverted trapezoidal shape and a short base of the inverted trapezoidal shape is on a side of the auxiliary electrode layer (5) proximal to the first electrode layer (2) and the second portion (4b) of the second electrode layer (4) has a triangular shape cross-section.

2. The organic light emitting diode display panel of claim 1, further comprising a pixel definition layer (6) in the inter-subpixel region on a side of the auxiliary electrode layer (5) distal to the base substrate (1).

3. The organic light emitting diode display panel of any one of claim 1 or 2, further comprising:
an organic layer (3) in the subpixel region on a side of the first electrode layer (2) distal to the base substrate (1), the organic layer (3) comprising the light emitting layer (3a); and
an insulating layer (7) in the inter-subpixel region on a side of the auxiliary electrode layer (5) proximal to the base substrate (1);
wherein a thickness of the organic layer (3) is no greater than a thickness of the insulating layer (7).

4. The organic light emitting diode display panel of claim 3, wherein the organic layer (3) further comprises one or more functional layer.

5. The organic light emitting diode display panel of any one of claims 1-4, wherein the organic light emitting diode display panel is a top-emission type display panel, the first electrode layer (2) is an anode layer, the second electrode layer (4) is a cathode layer, and the auxiliary electrode layer (5) is an auxiliary cathode layer.

6. A display apparatus, **characterized by** comprising an organic light emitting diode display panel of any one of claims 1 to 5.

7. A method of fabricating an organic light emitting diode display panel having a plurality of pixels, each of which includes a subpixel region and an inter-subpixel region, comprising:
forming a first electrode layer (2) on a base substrate (1);
forming an auxiliary electrode layer (5) in the inter-subpixel region in a same layer as a second electrode layer (4), wherein the auxiliary electrode layer (5) and the second electrode layer (4) are in contact with each other;
forming a light emitting layer (3a) in the subpixel region on a side of the first electrode layer (2) distal to the base substrate (1); and
forming the second electrode layer (4) on a side of the light emitting layer (3a) distal to the first electrode layer (2);
wherein the step of forming the second electrode layer (4) is performed subsequent to the step of forming the light emitting layer (3a), the step of forming the second electrode layer (4) comprising:
vapor depositing a metal material on side of the light emitting layer (3a) distal to the first electrode layer, thereby forming a first portion (4a) of the second electrode layer (4) in the subpixel region and a second portion (4b) in the inter-subpixel region, and the first portion (4a) being electrically connected to the auxiliary electrode layer (5) through the second portion (4b);
wherein the second electrode layer (4) is a transparent electrode layer formed by a transparent metal material; the auxiliary electrode layer (5) has a thickness larger than that of the first portion (4a) of the second electrode layer (4);
wherein the first portion of the second electrode layer is formed to have a thickness in a range of 5 nm to 20 nm; and the auxiliary electrode layer is formed to have a thickness in a range of 50 nm to 500 nm; and
**characterized in that**
the auxiliary electrode layer (5) is a non-transparent electrode layer formed by a non-transparent metal material;
a ratio between the thickness of the auxiliary electrode layer (5) to the thickness of the first portion (4a) of the second electrode layer (4) is in a range of 10 to 100; and
the auxiliary electrode layer (5) is formed to have a cross-section having an inverted trapezoidal shape, a short base of the inverted trapezoidal shape being on a side of the auxiliary electrode layer (5) proximal to the first electrode layer (2), and the second portion (4b) of the second electrode layer (4) is formed to have a triangular shape cross-section.

8. The method of claim 7, further comprising forming a pixel definition layer (6) in the inter-subpixel region on a side of the auxiliary electrode layer (5) distal to the base substrate (1).

9. The method of claim 7, further comprising:
forming an organic layer (3) comprising the light emitting layer (3a) in the subpixel region on a side of the first electrode layer (2) distal to the base substrate (1); and
forming an insulating layer (7) in the inter-subpixel region on a side of the auxiliary electrode layer (5) proximal to the base substrate (1) and on a side of the first electrode layer (2) distal to the base substrate (1);
wherein the organic layer (3) is formed to have a thickness no greater than a thickness of the insulating layer (7).

10. The method of claim 9, wherein the organic layer (3) is formed by an inkjet printing process.

## Patentansprüche

1. Organische Leuchtdioden-Anzeigetafel, die eine Vielzahl von Pixeln aufweist, wovon jedes einen Subpixelbereich und einen Inter-Subpixelbereich beinhaltet, die organische Leuchtdioden-Anzeigetafel umfassend:
ein Basissubstrat (1);
eine erste Elektrodenschicht (2) auf dem Basissubstrat (1);
eine lichtemittierende Schicht (3a) in dem Subpixelbereich auf einer Seite der ersten Elektrodenschicht (2) distal zu dem Basissubstrat (1);
eine zweite Elektrodenschicht (4) auf einer Seite der lichtemittierenden Schicht (3 a) distal zu
der ersten Elektrodenschicht (2); und
eine Hilfselektrodenschicht (5) in dem Inter-Subpixelbereich in einer selben Schicht wie die zweite Elektrodenschicht (4), wobei die Hilfselektrodenschicht (5) und die zweite Elektrodenschicht (4) miteinander in Kontakt sind;
wobei
die zweite Elektrodenschicht (4) einen ersten Abschnitt (4a) in dem Subpixelbereich und einen zweiten Abschnitt (4b) in dem Inter-Subpixelbereich umfasst, der erste Abschnitt (4a) durch den zweiten Abschnitt (4b) elektrisch mit der Hilfselektrodenschicht (5) verbunden ist und die Hilfselektrodenschicht (5) eine größere Stärke als die des ersten Abschnitts (4a) der zweiten Elektrodenschicht (4) aufweist;
der erste Abschnitt (4a) der zweiten Elektrodenschicht (4) eine Stärke in einem Bereich von 5 nm bis 20 nm aufweist; die Hilfselektrodenschicht (5) eine Stärke in einem Bereich von 50 nm bis 500 nm aufweist;
die zweite Elektrodenschicht (4) eine transparente Elektrodenschicht aus einem transparenten Metallmaterial ist, **dadurch gekennzeichnet, dass**
die Hilfselektrodenschicht (5) eine nicht-transparente
Elektrodenschicht aus einem nicht-transparenten Metallmaterial ist;
ein Verhältnis zwischen der Stärke der Hilfselektrodenschicht (5) und der Stärke des ersten Abschnitts (4a) der zweiten Elektrodenschicht (4) in einem Bereich von 10 bis 100 ist; und die Hilfselektrodenschicht (5) einen Querschnitt aufweist, der eine umgekehrte Trapezform aufweist und eine kurze Basis der umgekehrten Trapezform auf einer Seite der Hilfselektrodenschicht (5) proximal zu der ersten Elektrodenschicht (2) ist und der zweite Abschnitt (4b) der zweiten Elektrodenschicht (4) eine dreieckige Querschnittsform aufweist.

2. Organische Leuchtdioden-Anzeigetafel nach Anspruch 1, ferner umfassend eine Pixeldefinitionsschicht (6) in dem Inter-Subpixelbereich auf einer Seite der Hilfselektrodenschicht (5) distal zu dem Basissubstrat (1).

3. Organische Leuchtdioden-Anzeigetafel nach einem der Ansprüche 1 oder 2, ferner umfassend:
eine organische Schicht (3) in dem Subpixelbereich auf einer Seite der ersten Elektrodenschicht (2) distal zu dem Basissubstrat (1), die organische Schicht (3) umfassend die lichtemittierende Schicht (3a); und
eine Isolierschicht (7) in dem Inter-Subpixelbereich auf einer Seite der Hilfselektrodenschicht (5) proximal zu dem Basissubstrat (1);
wobei die Stärke der organischen Schicht (3) nicht größer ist als die Stärke der Isolierschicht (7).

4. Organische Leuchtdioden-Anzeigetafel nach Anspruch 3, wobei die organische Schicht (3) ferner eine oder mehrere funktionelle Schichten umfasst.

5. Organische Leuchtdioden-Anzeigetafel nach einem der Ansprüche 1 bis 4, wobei die organische Leuchtdioden-Anzeigetafel eine Anzeigetafel vom Typ Topemittierend ist, die erste Elektrodenschicht (2) eine Anodenschicht ist, die zweite Elektrodenschicht (4) eine Kathodenschicht ist und die Hilfselektrodenschicht (5) eine Hilfskathodenschicht ist.

6. Anzeigevorrichtung, **dadurch gekennzeichnet, dass** sie eine organische Leuchtdioden-Anzeigetafel nach einem der Ansprüche 1 bis 5 umfasst.

7. Verfahren zum Herstellen einer organischen Leuchtdioden-Anzeigetafel, die eine Vielzahl von Pixeln aufweist, wovon jedes einen Subpixelbereich und einen Inter-Subpixelbereich beinhaltet, umfassend:
Bilden einer ersten Elektrodenschicht (2) auf einem Basissubstrat (1);
Bilden einer Hilfselektrodenschicht (5) in dem Inter-Subpixelbereich in einer selben Schicht wie eine zweite Elektrodenschicht (4), wobei die Hilfselektrodenschicht (5) und die zweite Elektrodenschicht (4) miteinander in Kontakt sind;
Bilden einer lichtemittierenden Schicht (3a) in dem Subpixelbereich auf einer Seite der ersten Elektrodenschicht (2) distal zu dem Basissubstrat (1); und
Bilden der zweiten Elektrodenschicht (4) auf einer Seite der lichtemittierenden Schicht (3a) distal zu der ersten Elektrodenschicht (2);
wobei
der Schritt eines Bildens der zweiten Elektrodenschicht (4) im Anschluss an den Schritt eines Bildens der lichtemittierenden Schicht (3a) ausgeführt wird, der Schritt eines Bildens der zweiten Elektrodenschicht (4) umfassend:
Aufdampfen eines Metallmaterials auf einer Seite der lichtemittierenden Schicht (3a) distal zu der ersten Elektrodenschicht, wodurch ein erster Abschnitt (4a) der zweiten Elektrodenschicht (4) in dem Subpixelbereich und ein zweiter Abschnitt (4b) in dem Inter-Subpixelbereich gebildet wird, und wobei der erste Abschnitt (4a) durch den zweiten Abschnitt (4b) elektrisch mit der Hilfselektrodenschicht (5) verbunden ist;
wobei die zweite Elektrodenschicht (4) eine transparente Elektrodenschicht ist, die aus einem transparenten Metallmaterial gebildet ist; die Hilfselektrodenschicht (5) eine größere Stärke aufweist als die des ersten Abschnitts (4a) der zweiten Elektrodenschicht (4);
wobei der erste Abschnitt der zweiten Elektrodenschicht gebildet ist, um eine Stärke in einem Bereich von 5 nm bis 20 nm aufzuweisen; und die Hilfselektrodenschicht gebildet ist, um eine Stärke in einem Bereich von 50 nm bis 500 nm aufzuweisen; und **dadurch gekennzeichnet, dass** die Hilfselektrodenschicht (5) eine nicht-transparente Elektrodenschicht ist, die durch ein nicht-transparentes Metallmaterial gebildet ist:
ein Verhältnis zwischen der Stärke
der Hilfselektrodenschicht (5) zu der Stärke der ersten (4a) der zweiten Elektrodenschicht (4) in einem Bereich von 10 bis 100 ist; und
die Hilfselektrodenschicht (5) gebildet ist, um einen Querschnitt aufzuweisen, der eine umgekehrte Trapezform aufweist, wobei eine kurze Basis der umgekehrten Trapezform auf einer Seite der Hilfselektrodenschicht (5) proximal zu der ersten Elektrodenschicht (2) ist, und der zweite Abschnitt (4b) der zweiten Elektrodenschicht (4) gebildet ist, um eine dreieckige Querschnittsform aufzuweisen.

8. Verfahren nach Anspruch 7, ferner umfassend ein Bilden einer Pixeldefinitionsschicht (6) in dem Inter-Subpixelbereich auf einer Seite der Hilfselektrodenschicht (5) distal zu dem Basissubstrat (1).

9. Verfahren nach Anspruch 7, ferner umfassend:
Bilden einer organischen Schicht (3), umfassend die lichtemittierende Schicht (3a), in dem Subpixelbereich auf einer Seite der ersten Elektrodenschicht (2) distal zu dem Basissubstrat (1); und
Bilden einer Isolierschicht (7) in dem Inter-Subpixelbereich auf einer Seite der Hilfselektrodenschicht (5) proximal zu dem Basissubstrat (1) und auf einer Seite der ersten Elektrodenschicht (2) distal zu dem Basissubstrat (1);
wobei die organische Schicht (3) gebildet ist, um eine Stärke nicht größer als eine Stärke der Isolierschicht (7) aufzuweisen.

10. Verfahren nach Anspruch 9, wobei die organische Schicht (3) durch einen Tintenstrahl-Druckprozess gebildet ist.

## Revendications

1. Panneau d'affichage à diodes électroluminescentes organiques comportant une pluralité de pixels, dont chacun comprend une région de sous-pixel et une région inter-sous-pixels, le panneau d'affichage à diodes électroluminescentes organiques comprenant :
un substrat de base (1) ;
une première couche d'électrode (2) sur le substrat de base (1) ;
une couche électroluminescente (3a) dans la région de sous-pixel d'un côté de la première couche d'électrode (2) distal par rapport au substrat de base (1) ;
une seconde couche d'électrode (4) d'un côté de la couche électroluminescente (3a) distal par rapport à
la première couche d'électrode (2) ; et
une couche d'électrode auxiliaire (5) dans la région inter-sous-pixels dans une même couche que la seconde couche d'électrode (4), dans lequel la couche d'électrode auxiliaire (5) et la seconde couche d'électrode (4) sont en contact l'une avec l'autre ;
dans lequel
la seconde couche d'électrode (4) comprend une première partie (4a) dans la région de sous-pixel et une seconde partie (4b) dans la région inter-sous-pixels, la première partie (4a) est connectée électriquement à la couche d'électrode auxiliaire (5) à travers la seconde partie (4b), et la couche d'électrode auxiliaire (5) a une épaisseur supérieure à celle de la première partie (4a) de la seconde couche d'électrode (4) ;
la première partie (4a) de la seconde couche d'électrode (4) a une épaisseur comprise entre 5 nm et 20 nm ; la couche d'électrode auxiliaire (5) a une épaisseur comprise entre 50 nm et 500 nm ;
la seconde couche d'électrode (4) est une couche d'électrode transparente constituée d'un matériau métallique transparent, **caractérisé en ce que**
la couche d'électrode auxiliaire (5) est une couche d'électrode
non transparente constituée d'un matériau métallique non transparent ;
un rapport entre l'épaisseur de la couche d'électrode auxiliaire (5) et l'épaisseur de la première partie (4a) de la seconde couche d'électrode (4) est compris entre 10 et 100 ; et la couche d'électrode auxiliaire (5) a une section transversale ayant une forme trapézoïdale inversée et une petite base de la forme trapézoïdale inversée se trouve d'un côté de la couche d'électrode auxiliaire (5) proximal par rapport à la première couche d'électrode (2) et la seconde partie (4b) de la seconde couche d'électrode (4) a une section transversale de forme triangulaire.

2. Panneau d'affichage à diodes électroluminescentes organiques selon la revendication 1, comprenant en outre une couche de définition de pixel (6) dans la région inter-sous-pixels d'un côté de la couche d'électrode auxiliaire (5) distal par rapport au substrat de base (1).

3. Panneau d'affichage à diodes électroluminescentes organiques selon l'une quelconque des revendications 1 ou 2, comprenant en outre :
une couche organique (3) dans la région de sous-pixel d'un côté de la première couche d'électrode (2) distal par rapport au substrat de base (1), la couche organique (3) comprenant la couche électroluminescente (3 a) ; et
une couche isolante (7) dans la région inter-sous-pixels d'un côté de la couche d'électrode auxiliaire (5) proximal par rapport au substrat de base (1) ;
dans lequel l'épaisseur de la couche organique (3) n'est pas supérieure à l'épaisseur de la couche isolante (7).

4. Panneau d'affichage à diodes électroluminescentes organiques selon la revendication 3, dans lequel la couche organique (3) comprend en outre une ou plusieurs couches fonctionnelles.

5. Panneau d'affichage à diodes électroluminescentes organiques selon l'une quelconque des revendications 1 à 4, dans lequel le panneau d'affichage à diodes électroluminescentes organiques est un panneau d'affichage à émission par le haut, la première couche d'électrode (2) est une couche anodique, la seconde couche d'électrode (4) est une couche cathodique et la couche d'électrode auxiliaire (5) est une couche cathodique auxiliaire.

6. Appareil d'affichage, **caractérisé en ce qu'**il comprend un panneau d'affichage à diodes électroluminescentes organiques selon l'une quelconque des revendications 1 à 5.

7. Procédé de fabrication d'un panneau d'affichage à diodes électroluminescentes organiques comportant une pluralité de pixels, dont chacun comprend une région de sous-pixel et une région inter-sous-pixels, comprenant :
la formation d'une première couche d'électrode (2) sur un substrat de base (1) ;
la formation d'une couche d'électrode auxiliaire (5) dans la région inter-sous-pixels dans une même couche qu'une seconde couche d'électrode (4), dans lequel la couche d'électrode auxiliaire (5) et la seconde couche d'électrode (4) sont en contact l'une avec l'autre ;
la formation d'une couche électroluminescente (3a) dans la région de sous-pixel d'un côté de la première couche d'électrode (2) distal par rapport au substrat de base (1) ; et
la formation d'une seconde couche d'électrode (4) d'un côté de la couche électroluminescente (3a) distal par rapport à la première couche d'électrode (2) ;
dans lequel
l'étape de formation de la seconde couche d'électrode (4) est effectuée après l'étape de formation de la couche électroluminescente (3a), l'étape de formation de la seconde couche d'électrode (4) comprenant :
le dépôt en phase vapeur d'un matériau métallique sur le côté de la couche électroluminescente (3a) distal par rapport à la première couche d'électrode, formant ainsi une première partie (4a) de la seconde couche d'électrode (4) dans la région de sous-pixel et une seconde partie (4b) dans la région inter-sous-pixels, la première partie (4a) étant connectée électriquement à la couche d'électrode auxiliaire (5) par l'intermédiaire de la seconde partie (4b) ;
dans lequel la seconde couche d'électrode (4) est une couche d'électrode transparente formée par un matériau métallique transparent ; la couche d'électrode auxiliaire (5) a une épaisseur supérieure à celle de la première partie (4a) de la seconde couche d'électrode (4) ;
dans lequel la première partie de la seconde couche d'électrode est formée pour avoir une épaisseur comprise entre 5 nm et 20 nm ; et la couche d'électrode auxiliaire est formée pour avoir une épaisseur comprise entre 50 nm et 500 nm ; et **caractérisé en ce que** la couche d'électrode auxiliaire (5) est une couche d'électrode non transparente formée par un matériau métallique non transparent :
un rapport entre l'épaisseur de
la couche d'électrode auxiliaire (5) et l'épaisseur de la première partie (4a) de la seconde couche d'électrode (4) est compris entre 10 et 100 ; et
la couche d'électrode auxiliaire (5) est formée pour avoir une section transversale ayant une forme trapézoïdale inversée, une petite base de la forme trapézoïdale inversée se trouvant d'un côté de la couche d'électrode auxiliaire (5) proximal par rapport à la première couche d'électrode (2), et la seconde partie (4b) de la seconde couche d'électrode (4) est formée pour avoir une section transversale de forme triangulaire.

8. Procédé selon la revendication 7, comprenant en outre la formation d'une couche de définition de pixel (6) dans la région inter-sous-pixels d'un côté de la couche d'électrode auxiliaire (5) distal par rapport au substrat de base (1).

9. Procédé selon la revendication 7, comprenant en outre :
la formation d'une couche organique (3a) comprenant la couche électroluminescente (3a) dans la région de sous-pixel d'un côté de la première couche d'électrode (2) distal par rapport au substrat de base (1) ; et
la formation d'une couche isolante (7) dans la région inter-sous-pixels d'un côté de la couche d'électrode auxiliaire (5) proximal par rapport au substrat de base (1) et d'un côté de la première couche d'électrode (2) distal par rapport au substrat de base (1) ;
dans lequel la couche organique (3) est formée pour avoir une épaisseur non supérieure à l'épaisseur de la couche isolante (7).

10. Procédé selon la revendication 9, dans lequel la couche organique (3) est formée par un procédé d'impression à jet d'encre.
